# EUROPÄISCHE PATENTSCHRIFT

(11) **EP 3 555 339 B1**
(45) Veröffentlichungstag und Bekanntmachung des Hinweises auf die Patenterteilung: **19.10.2022**
(21) Anmeldenummer: 17804108.3
(22) Anmeldetag: 09.11.2017
(51) Int. Cl.: C23C 14/32, C23C 14/58, C23C 28/00

(54) **VERFAHREN ZUM BESCHICHTEN EINES METALLISCHEN BAUTEILS MIT EINER VERSCHLEISSSCHUTZSCHICHT**
METHOD FOR COATING A METAL COMPONENT WITH AN ANTI-WEAR LAYER
PROCÉDÉ D'APPLICATION D'UNE COUCHE ANTI-USURE SUR UN ÉLÉMENT MÉTALLIQUE

(30) Priorität: 19.12.2016 DE 102016225449
(43) Veröffentlichungstag der Anmeldung: 23.10.2019
(73) Patentinhaber: Robert Bosch GmbH, 70442 Stuttgart (DE)
(72) Erfinder: GUENTHER, Marcus, 70839 Gerlingen (DE)
(86) Internationale Anmeldenummer: PCT/EP2017/078769
(87) Internationale Veröffentlichungsnummer: WO 2018/114130

(56) Entgegenhaltungen:
- EP-A1- 1 772 532
- WO-A1-2016/042945
- DE-A1-102009 003 192
- JP-A- S5 333 777
- KR-A- 20120 120 471
- US-A1- 2008 220 257

## Beschreibung

Die vorliegende Erfindung betrifft ein Verfahren zum Beschichten eines metallischen Bauteils mit einer harten Verschleißschutzschicht, welche durch ein Plasmaverfahren zumindest einschichtig über zumindest einen Teil der Oberfläche es Bauteils aufgetragen wird. Weiterhin betrifft die Erfindung auch ein damit beschichtetes metallisches Bauteil sowie ein Kraftstoffeinspritzsystem eines Kraftfahrzeuges mit solchen metallischen Bauteilen als Systemkomponenten.

Das Einsatzgebiet der Erfindung erstreckt sich vornehmlich auf die Kraftfahrzeugtechnik insbesondere auf Kraftstoffeinspritzsysteme. Deren metallische Bauteile, wie beispielsweise Ventilsitze von Kraftstoffinjektoren, Gleitlagerstellen bei Hochdruckpumpen und dergleichen sind im Betrieb starken Drücken und Reibbeanspruchungen ausgesetzt, so dass derartig tribologisch hoch beanspruchte Oberflächen hier interessierender metallischer Bauteile mit einer Verschleißschutzschicht versehen sind, welche insbesondere die Reibwerte in tribologischen Kontakten deutlichen senken. Derartige Verschleißschutzschichten enthalten beispielsweise Chromnitrit, Titannitrit oder DLC (diamond-like carbon). Derartige Verschleißschutzschichten kommen neben der Einspritztechnik auch in der Werkzeugtechnik zum Einsatz, also als Werkzeugbeschichtungen.

### Stand der Technik

Ein im Stand der Technik allgemein bekanntes Verfahren, um derartige Verschleißschutzschichten abzuscheiden ist die Vakuumbogenverdampfung oder PVD-Verfahren (PVD= physical vapor deposition).

Die DE 10 2009 003 192 A1 offenbart eine Verschleißschutzschichtanordnung, die im PVD-Verfahren, vorzugsweise unter Vakuum, auf die zu schützende Oberfläche eines Bauteils aufgebracht ist. Die Verschleißschutzschichtanordnung weist eine aus tetraedrisch gebundenem amorphen Kohlenstoff gebildete oder einen Anteil an tetraedrisch gebundenem amorphen Kohlenstoff aufweisende Verschleißschutzschicht sowie eine Titan aufweisende Haftschicht zwischen dem Bauelement und der Verschleißschutzschicht auf. Die Haftschicht weist zusätzlich neben Titan wenigstens ein oxidationsbeständiges Element auf. Hierdurch wird die hohe chemische Reaktivität von Titan vermindert und die Oxidationsbeständigkeit in der Haftschicht erhöht, was der Beständigkeit der gesamten Verschleißschutzanordnung zu Gute kommt. Auch die Haftschicht wird im PVD-Verfahren aufgebracht.

Prozessbedingt entstehen bei diesem Verfahren sogenannte Droplets, also grobkörnige Materialausscheidungen, die von der Oberfläche der Beschichtung hervorstehen, mit einer Korngröße von einigen µm. Hierdurch erhöht sich nachteilhaft die Oberflächenrauhheit der so beschichteten metallischen Bauteile, was wiederum einen negativen Einfluss auf das Reib- und Verschleißverhalten des Bauteils ausübt.

Zwar können derartige Droplets durch eine elektromagnetische Filterung des Beschichtungsteilchenstroms vermindert werden; dieses Verfahren ist jedoch recht aufwendig, insbesondere durch einen energieintensiven Filteraufbau. Zudem ist eine Großserienanwendung systembedingt hiermit nicht realisierbar, was nachteilhaft im Hinblick auf den vorstehend angegebenen Anwendungsbereich in der Kraftfahrzeugtechnik ist.

Ein Glätten der Oberfläche der Verschleißschutzschicht zum Entfernen der Droplets hinterlässt wiederum Löcher in der Schichtoberfläche, welche ebenfalls eine hohe Rauheit erzeugen, aber auch teilweise die Bauteiloberfläche freilegen. Derartige Löcher wären Angriffspunkte für chemische Zersetzungsprozesse oder Korrosion.

In KR-A-20120120471 und JPS4945517B B2 wird Polieren der Oberfläche einer Zwischenschicht mit Droplets beschrieben, auf welche anschließend eine härtere Verschleißschutzschicht aufgebracht wird.

In EP-A-3196332 wird eine zweilagige DLC-Schicht, aus einer innen liegenden härteren DLC-Schicht und einer weicheren Einlaufschicht, poliert.

Es ist die Aufgabe der vorliegenden Erfindung ein Verfahren zum Beschichten eines metallischen Bauteils mit einer Verschleißschutzschicht der hier interessierenden Art sowie ein damit beschichtetes metallisches Bauteil dahingehend weiter zu verbessern, dass glatte dropletfreie Oberflächen machbar sind, die sich mittels eines Plasmaverfahrens in Großserie herstellen lassen.

### Offenbarung der Erfindung

Die Aufgabe wird verfahrenstechnisch durch Anspruch 1 gelöst. Besondere Ausführungsarten des erfindungsgemäßen Verfahrens sind in Patentansprüchen 2-6 angegeben.

Die Erfindung schließt die verfahrenstechnische Lehre ein, dass nach dem Auftragen einer harten Verschleißschutzschicht per Plasmaverfahren auf die Oberfläche eines Bauteils in einem Folgeschritt die hierbei abgeschiedenen Droplets zunächst mechanisch entfernt werden, und dass anschließend auf die Oberfläche der aufgetragenen und mechanisch bearbeiteten Verschleißschutzschicht eine demgegenüber weichere Einlaufschicht aufgetragen wird.

Gemäß einer bevorzugten Ausführungsform ist die harte Verschleißschutzschicht als eine tetraedrische wasserstofffreie amorphe Kohlenstoffschicht (ta-C) ausgebildet, wogegen die demgegenüber weichere Einlaufschicht als eine wasserstoffhaltige amorphe Kohlenstoffschicht (a-C:H) ausgebildet ist. Insbesondere diese spezielle Materialkombination erweist sich sowohl als reibarm als auch hochbeständig an den hier interessierenden tribologisch hochbelasteten metallischen Bauteilen.

Es wird vorgeschlagen, dass die Einlaufschicht ebenfalls durch ein Plasmaverfahren aufgetragen wird, wobei vorteilhafterweise ein Plasmareinigungs- oder Plasmaaktivierungsverfahren dem Schritt vorausgehen soll, um die Schichthaftung zu maximieren. Ferner verankert sich die Einlaufschicht auch in den in Folge des vorausgegangenen mechanischen Bearbeitungsschritts in die Verschleißschutzschichtoberfläche eingebrachten Mikrodellen, was die Hafteigenschaft weiter verbessert.

Die durch den Verfahrenszwischenschritt durchgeführte mechanische Entfernung der Droplets der harten Verschleißschutzschicht kann beispielsweise mittels Schleifen oder Bürsten durchgeführt werden. Besonders geeignet ist ein Band-, Schlepp-, oder Strömungsfinishen.

Zur Erzielung eines höchst möglichen Automatisierungsgrads für die Beschichtung wird vorgeschlagen, dass die per Plasmaverfahren auf die Oberfläche des Bauteils aufgetragene harte Verschleißschutzschicht durch gepulste oder ungepulste Vakuumbogenverdampfung aufgetragen wird. Für die weichere Einlaufschicht kann das PVD-Verfahren oder das PECVD-Verfahren (PECVD= plasma enhanced chemical vapor deposition) angewendet werden.

Gemäß einer weiteren die Erfindung verbessernden Maßnahme wird vorgeschlagen, dass vor dem Auftragen der harten Verschleißschutzschicht mindestens eine metallische Haftschicht auf die Oberfläche des Bauteils aufgetragen wird. Die Haftschicht erhöht die Beständigkeit der harten Verschleißschutzschicht und kann ebenfalls per Plasmabeschichtung automatisiert in einer Vakuumbeschichtungsanlage durchgeführt werden, welcher zu diesem Zweck Titan abscheidet. Der aus Titan bestehenden Haftschicht kann außerdem ein oxidationsbeständiges Element zugemengt werden, um die hohe chemische Reaktivität von Titan zu vermindern. Ferner kann die Haftschicht auch mehrschichtig ausgebildet sein und beispielsweise aus einer einen Chrom-Anteil aufweisenden ersten Haftschicht und einer einen Kohlenstoff-Anteil aufweisenden zweiten Haftschicht bestehen.

Weitere, die Erfindung verbessernde Maßnahmen werden nachstehend gemeinsam mit der Beschreibung der bevorzugten Ausführungsbeispiele der Erfindung anhand von Figuren näher dargestellt.

### Ausführungsbeispiele

Es zeigt:
- Figur 1: eine schematische Darstellung eines erfindungsgemäß mehrschrittig bearbeiteten metallischen Bauteils in Bearbeitungsschritten I bis III, und
- Figur 2: einen Ablaufplan einer vollständigen Bearbeitungsschrittfolge zum Beschichten des Bauteils mit einer Verschleißschutzschicht.

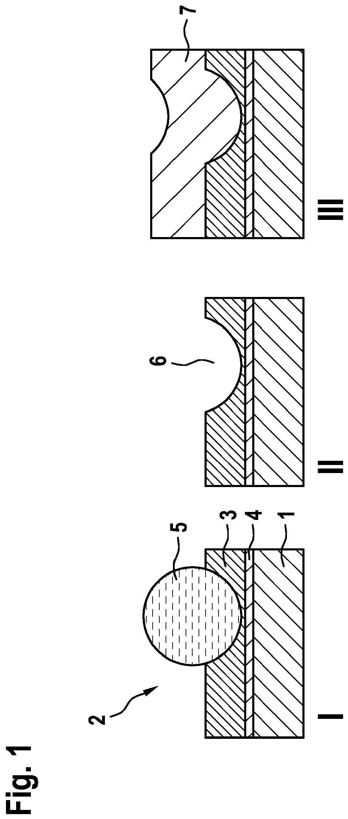

Gemäß Figur 1 ist ein hier nur schematisch dargestelltes metallisches Bauteil 1 seitens einer tribologisch beanspruchten Oberfläche 2 mit einer Verschleißschutzschicht 3 überzogen, welche als eine tetraedrische wasserstofffreie amorphe Kohlenstoffschicht (ta-C) ausgebildet ist. Diese harte Verschleißschutzschicht 3 wird vermittels einer metallischen Haftschicht 4 per Plasmaverfahren auf die Oberfläche des Bauteils 1 aufgetragen. Die bei diesem ersten Verfahrensschritt I aufgebrachte harte Verschleißschutzschicht 3 weist von der Oberfläche hervorstehende Droplets 5 auf, welche durch das verwendete Plasmaverfahren anstehen und die Oberflächenrauigkeit stark erhöhen.

Im nachfolgenden Verfahrensschritt II werden diese Droplets 5 mechanisch durch Schleifen entfernt. Hierdurch entstehen Mikrodellen 6 in der mit der Verschleißschutzschicht 3 versehenen Oberfläche des Bauteils 1.

Im nachfolgenden Verfahrensschritt III wird auf die Oberfläche der aufgetragenen und mechanisch bearbeiteten Verschleißschutzschicht 3 eine demgegenüber weichere Einlaufschicht 7 per Plasmaverfahren aufgetragen. Die gegenüber der Verschleißschutzschicht 3 hinsichtlich der Materialhärte weichere Einlaufschicht 7 ist bei diesem Ausführungsbeispiel als ein wasserstoffhaltige amorphe Kohlenstoffschicht (a-C:H) ausgebildet. Hierdurch verflachen sich auch die Mikrodellen 6, so dass sich eine insgesamt glattere und damit reibarmere Verschleißschutzschicht ergibt.

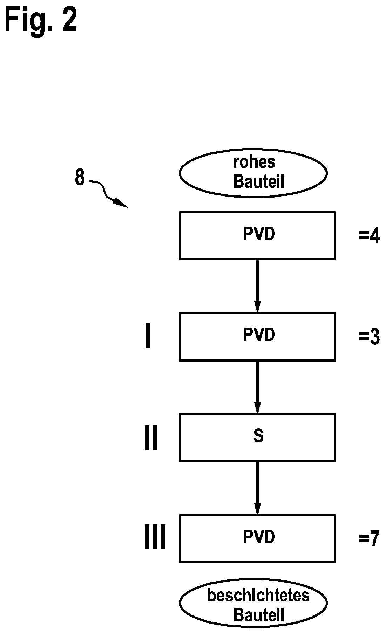

Gemäß Figur 2 erfolgt die Beschichtung des - hier nicht dargestellten - metallischen Bauteils, indem in einer Vakuumbeschichtungsanlage 8 zunächst per PVD-Verfahren eine metallische Haftschicht 4 auf die Oberfläche des unbeschichteten metallischen Bauteils 1 aufgetragen wird. Anschließend wird in dem Verfahrensschritt I mittels PVD-Verfahren die harte Verschleißschutzschicht 3 auf die Haftschicht 4 aufgetragen. Nach der mechanischen Bearbeitung erfolgt ein Plasmareinigungs-Verfahrenszwischenschritt Nachfolgend erfolgt ein mechanisches entfernen von auf der harten Verschleißschutzschicht 3 abgeschiedenen Droplets 5 durch Schleifen im Verfahrensschritt II. Nachfolgend wird im PVD- oder PECVD-Verfahren innerhalb derselben Vakuumbeschichtungsanlage 8 die gegenüber der harten Verschleißschutzschicht 3 weichere Einlaufschicht 7 im Verfahrensschritt III aufgetragen. Es ergibt sich im Ergebnis dessen die erfindungsgemäß hergestellte Beschichtung des metallischen Bauteils 1.

## Patentansprüche

1. Verfahren zum Beschichten eines metallischen Bauteils (1) mit einer harten Verschleißschutzschicht (3), welche durch ein Plasmaverfahren zumindest einschichtig über zumindest einen Teil der Oberfläche des Bauteils (1) aufgetragen wird,
**dadurch gekennzeichnet, dass** auf der Oberfläche der aufgetragenen harten Verschleißschutzschicht (3) abgeschiedene Droplets (5) mechanisch entfernt werden, und dass anschließend auf die Oberfläche der aufgetragenen und mechanisch bearbeiteten Verschleißschutzschicht (3) eine demgegenüber weichere Einlaufschicht (7) aufgetragen wird, wobei sich die Einlaufschicht (7) in den in Folge des vorausgegangenen mechanischen Bearbeitungsschritts in die Verschleißschutzschichtoberfläche eingebrachten Mikrodellen verankert.

2. Verfahren nach Anspruch 1,
**dadurch gekennzeichnet, dass** die Einlaufschicht (7) ebenfalls durch ein Plasmaverfahren aufgetragen wird, wobei dem ein Plasmareinigungs- oder Plasmaaktivierungsverfahrensschritt vorausgeht.

3. Verfahren nach Anspruch 1,
**dadurch gekennzeichnet, dass** die mechanische Entfernung der Droplets (5) mittels Schleifen oder Bürsten durchgeführt wird.

4. Verfahren nach Anspruch 1,
**dadurch gekennzeichnet, dass** die per Plasmaverfahren auf die Oberfläche des Bauteils (1) aufgetragene harte Verschleißschutzschicht (3) und/oder die weichere Einlaufschicht (7) durch PVD- oder PECVD-Verfahren, insbesondere Vakuumbogenverdampfung, aufgetragen wird.

5. Verfahren nach Anspruch 1,
**dadurch gekennzeichnet, dass** vor dem Auftragen der harten Verschleißschutzschicht (3) mindestens eine metallische Haftschicht (4) auf die Oberfläche des Bauteils (1) aufgetragen wird.

6. Verfahren nach einem der vorstehenden Ansprüche,
**dadurch gekennzeichnet, dass** die Beschichtungsschritte zum Aufbringen der Einlaufschicht (7), der Verschleißschutzschicht (3) und der optionalen Haftschicht (4) in derselben Vakuumbeschichtungsanlage (8) durchgeführt werden.

## Claims

1. Process for coating a metallic component part (1) with a hard antiwear layer (3) which is applied over at least part of the surface of the component part (1) in at least one layer by a plasma process, **characterized in that** droplets (5) deposited on the surface of the applied hard antiwear layer (3) are mechanically removed and that subsequently a comparatively softer abradable layer (7) is applied to the surface of the applied and mechanically treated antiwear layer (3), wherein the abradable layer (7) is anchored into the microdents introduced into the antiwear layer surface as a result of the preceding mechanical processing step.

2. Process according to Claim 1, **characterized in that** the abradable layer (7) is likewise applied by a plasma process, wherein said process is preceded by a plasma cleaning or plasma activation process step.

3. Process according to Claim 1, **characterized in that** the mechanical removal of the droplets (5) is performed by polishing or brushing.

4. Process according to Claim 1, **characterized in that** the hard antiwear layer (3) applied to the surface of the component part (1) by a plasma process and/or the softer abradable layer (7) is/are applied by a PVD or PECVD process, in particular vacuum arc evaporation.

5. Process according to Claim 1, **characterized in that** prior to application of the hard antiwear layer (3) at least one metallic adhesion-promoting layer (4) is applied to the surface of the component part (1).

6. Process according to any of the preceding claims, **characterized in that** the coating steps for applying the abradable layer (7), the antiwear layer (3) and the optional adhesion-promoting layer (4) are performed in the same vacuum coating plant (8).

## Revendications

1. Procédé de revêtement d'un composant métallique (1) avec une couche anti-usure dure (3) qui est appliquée par un procédé au plasma en au moins une couche sur au moins une partie de la surface du composant (1),
**caractérisé en ce que** des gouttelettes (5), déposées sur la surface de la couche anti-usure dure (3), sont éliminées mécaniquement, et **en ce qu'**une couche d'introduction (7) comparativement plus souple est ensuite appliquée sur la surface de la couche anti-usure (3), appliquée et traitée mécaniquement, la couche d'introduction (7) étant ancrée dans les microdéformations, réalisées dans la surface de la couche anti-usure, à la suite de l'étape de traitement mécanique précédente.

2. Procédé selon la revendication 1, **caractérisé en ce que** la couche d'introduction (7) est également appliquée par un procédé au plasma qui est précédé d'une étape de procédé de nettoyage au plasma ou d'activation au plasma.

3. Procédé selon la revendication 1, **caractérisé en ce que** les gouttelettes (5) sont éliminées mécaniquement par meulage ou brossage.

4. Procédé selon la revendication 1, **caractérisé en ce que** la couche anti-usure dure (3) appliquée à la surface du composant (1) par un procédé au plasma et/ou la couche d'introduction plus souple (7) sont appliquées par des procédés PVD ou PECVD, en particulier par évaporation à l'arc sous vide.

5. Procédé selon la revendication 1, **caractérisé en ce qu'**au moins une couche d'adhérence métallique (4) est appliquée sur la surface du composant (1) avant l'application de la couche anti-usure dure (3).

6. Procédé selon l'une des revendications précédentes, **caractérisé en ce que** les étapes de revêtement destinées à appliquer la couche d'introduction (7), la couche anti-usure (3) et la couche adhésive facultative (4) sont réalisées dans le même système de revêtement sous vide (8).
